# EUROPEAN PATENT APPLICATION

(11) **EP 0 542 329 A1**
(43) Date of publication of application: **19.05.1993**
(21) Application number: 92203204.0
(22) Date of filing: 19.10.1992
(51) Int. Cl.: H03G 3/20

(54) **Amplifier with adjustable output level**

(30) Priority: 15.11.1991 NL 9101907
(71) Applicant: ERICSSON RADIO SYSTEMS B.V., 7814 VA Emmen (NL)
(72) Inventor: Vrijkorte, Marcel Johannes Gerhardus, NL-7812 VH Emmen (NL); Post, Henrik Andries, NL-7815 CB Emmen (NL)
(74) Representative: van der Arend, Adrianus G.A., Ir.

(57) **Abstract**

Amplifier comprising, in series between an input for receiving an alternating current input signal and an output for supplying an output signal, an input stage and an output stage and, in addition, a feedback circuit between the output and a gain factor control input of the input stage, the feedback circuit having a rectifying circuit with a semiconductor rectifying element for rectifying an alternating current signal derived from the output signal, a reference source for supplying a reference signal, and a difference amplifier for forming the difference between the rectified derived signal and the reference signal, in order to generate and to supply to the control input a control signal for adjusting a gain factor of the input stage, in order to keep the level of the output signal essentially constant, in which the feedback circuit has another rectifying circuit containing another rectifying element which is of the type of the first rectifying element, the difference amplifier receives the reference signal after being rectified by the other rectifying circuit, and the shape of the reference signal is essentially identical to the shape of the derived signal. So long as the shape of the reference signal is essentially identical to the shape of the derived signal, the frequency of the reference signal may be considerably lower than the average frequency of the derived signal.

## Description

The invention relates to an amplifier comprising, in series between an input for receiving an alternating current input signal and an output for supplying an output signal, an input stage and an output stage and, in addition, a feedback circuit between the output and a gain factor control input of the input stage, the feedback circuit having a rectifying circuit with a semiconductor rectifying element for rectifying an alternating current signal derived from the output signal, a reference source for supplying a reference signal, and a difference amplifier for forming the difference between the rectified derived signal and the reference signal, in order to generate and to supply to the control input a control signal for adjusting a gain factor of the input stage, in order to keep the level of the output signal essentially constant.

An amplifier of this type is known in practice. Because the amplifier is intended to keep the level of the output signal essentially constant, independent of the instantaneous level of the input signal, an amplifier of this type is suitable for use as the power amplifier of a transmitter, thereby establishing a particular transmitter power which is permitted according to national regulations.

In the case of the known amplifier, the reference signal is established once and for all by the sizing of particular components of the amplifier or by being set by a user.

The signal derived from the output signal is derived by means of an attenuator to suppress unwanted feedback to the output signal from the feedback circuit. As a consequence, the current through the semiconductor rectifying element will be relatively small, and therefore the rectifying element will, in general, operate in a nonlinear region of its operating characteristic. Because, in addition, the operating characteristic of the semiconductor rectifying element is temperature-dependent, the control signal supplied to the input stage for the purpose of adjusting its gain factor will change nonlinearly as the temperature of the semiconductor element changes relative to the temperature at which the reference signal was set. Because the temperature of the semiconductor element during normal use of the amplifier is not generally known in advance, and because it can vary, the level of the output signal and therefore the output power cannot be accurately defined in advance. If the amplifier is used as the power amplifier of a transmitter, the output level or the power will therefore have to be set at a lower level or power than permitted by regulations, in order to comply at all times with the regulations within a temperature range met in practice, as a consequence of which the reception range in a system having an amplifier of this type is limited.

The object of the invention is to overcome the drawbacks of the known amplifier.

This object is achieved according to the invention, in the case of the amplifier of the type described in the preamble, in that the feedback circuit has another rectifying circuit containing another rectifying element which is of the type of the first rectifying element, in that the difference amplifier receives the reference signal after being rectified by the other rectifying circuit, and in that the shape of the reference signal is essentially identical to the shape of the derived signal.

Because the two rectifying elements are essentially identical, their operating characteristics, including the temperature-dependence, will be essentially identical, as a consequence of which errors in the rectified signals caused by nonlinearities and temperature changes will be compensated by the difference amplifier. This ensures that a level of the output signal or of the output power of the amplifier, once set, is maintained in the event of temperature changes of the rectifying elements.

The abovementioned advantage of the amplifier according to the invention is retained if the frequency of the reference signal is lower than the average frequency of the derived signal. Because a generator for generating an alternating voltage of lower frequency can be of simple construction, the reference source containing a generator of this type can therefore also be of simple construction. It has been found that, if the amplifier is used as the power amplifier of a transmitter to give an output signal having a frequency of 25-50 MHz, a reference signal of the same shape and having a frequency of only 1 kHz gives good results.

The rectifying elements are preferably formed on the same semiconductor substrate. This ensures that the two semiconductor elements have essentially the same temperature, in order to obtain as efficient an operation of the amplifier as possible.

Because the level of the output signal of the amplifier can be set at each moment, independently of the temperature of the two semiconductor elements, the amplifier according to the invention can be constructed incorporating a settable reference source, both with regard to the shape of the reference signal and to its amplitude.

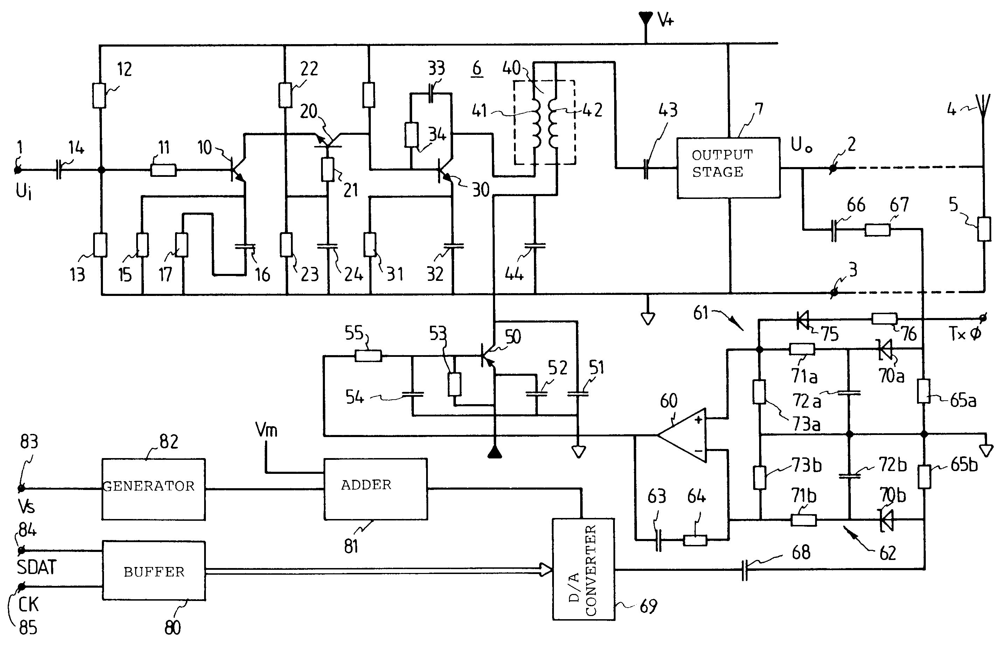

Other properties and advantages of the amplifier according to the invention will become apparent from the following explanation of an embodiment of an amplifier according to the invention, with reference to the drawing which shows a diagram of the amplifier.

The amplifier shown has an input 1 for receiving an alternating current input signal Uᵢ and an output 2 for supplying an output signal Uₒ. The amplifier may be an amplifier of a transmitter, with the ability according to the invention to set and to maintain the level of the output signal or of the output power accurately at a particular value, said value in particular being a maximum value prescribed by regulations. Thus the figure shows connected to the output 2 and to a mass connection 3, possibly remotely as shown by the dashed lines an antenna 4 and a load resistance 5.

Between the input 1 and the output 2, an input stage 6 and an output stage 7 are arranged in series. The input stage 6 and the output stage 7 may be of known design. The output stage 7 comprises in particular a power amplifier and will not be explained hereinafter.

The input stage 6 comprises an npn input transistor 10 whose base is connected, via a resistor 11, to a voltage divider containing the resistors 12 and 13 between a positive supply terminal V+ and mass for the purpose of setting up the transistor 10. The junction point of the resistors 11, 12 and 13 is connected to the input 1 via a decoupling capacitor 14. The emitter of the transistor 10 is connected to mass via a resistor 15, and at the same time is connected to mass via a capacitor 16 in series with a resistor 17.

The collector of the transistor 10 is connected to the emitter of an npn transistor 20 whose base is connected, via a resistor 21, to a junction point of a voltage divider which consists of the resistors 22 and 23 between the positive supply terminal V+ and mass for the purpose of adjusting the transistor 20. The junction point of the resistors 21, 22 and 23 is connected also to mass via a capacitor 24.

The collector of the transistor 20 is connected to the base of an npn transistor 30 whose emitter is connected to mass via a resistor 31 and also via a capacitor 32. The collector of the transistor 30 is connected to the base of transistor 30 via a capacitor 33 in series with a resistor 34.

The input stage 6 also has a transformer 40 having a first winding 41 and a second winding 42. A terminal of the first winding 41 is connected to the collector of the transistor 30. The other terminal of the first winding 41, together with a terminal of the second winding 42, is connected to an input of an output stage 7 via a decoupling capacitor 43. The other terminal of the second winding 42 is connected to mass via a capacitor 44, and it is also connected to the collector of a pnp control transistor 50.

The collector of the transistor 50 is connected to mass via a capacitor 51. The capacitor 51 has a relatively high value, as a result of which the collector of the transistor 50 forms a virtual earth connection point. The emitter of the transistor 50 is connected to the positive supply terminal V+ and, via a capacitor 52 having a relatively small value, to mass. The base of the transistor 50 is connected to the positive supply terminal V+ via a resistor 53 and, via a capacitor 54 having a relatively small value, to mass.

The base of the transistor 50 is connected also to an output of a difference amplifier 60 via a resistor 55. A non-inverting input of the difference amplifier 60 receives a rectified signal from a first rectifying circuit 61, and an inverting input of the difference amplifier 60 receives another rectified signal from a second rectifying circuit 62. Between the output and the inverting input of the difference amplifier 60, a capacitor 63 is connected in series with a resistor 64.

An input of each rectifying circuit 61, 62 is connected to mass via a resistor 65a and 65b, respectively. An input of the first rectifying circuit 61 is connected, via a capacitor 66 in series with a resistor 67, to the output 2 of the amplifier. The resistors 65a and 67 form an attenuator, as a consequence of which the signal derived from the output signal of the output stage 2 is relatively small at the input of the first rectifying circuit 61, and unwanted feedback from the first rectifying circuit 61 to the output 2 is suppressed.

An input of the second rectifying circuit 62 is connected to an analog output of a digital/analog converter 69 via a capacitor 68. The converter 69 supplies, via the capacitor 68, an alternating current reference signal to the second rectifying circuit 62.

The rectifying circuits 61 and 62 each comprise a rectifying element, which in particular is a Schottky diode with a threshold voltage of only about 0.3 V, 70a and 70b, respectively, followed by a low-pass filter comprising a resistor 71a and 71b, respectively, between the rectifying elements 70a and 70b, respectively, and the non-inverting input and the inverting input, respectively, of the difference amplifier 60 and a capacitor 72a and 72b, respectively, between the junction point of the rectifying element 70a, 70b and the associated resistor 71a, 71b and mass. The non-inverting input and the inverting input of the difference amplifier 60 are connected to mass via a resistor 73a and 73b, respectively.

The junction point of the resistors 71a and 73a (the output of the first rectifying circuit 61) is connected to the cathode of a diode 75, and connected to a control input TXØ via a resistor 76 in series with the diode 75.

As was stated earlier, the digital/analog converter 69 is intended to supply, via the capacitor 68, an alternating current reference signal to the input of the second rectifying circuit (the anode of the diode 70b). To this end, the converter 69 receives at its digital inputs a digital value from a buffer 80, and at a reference input an analog reference base signal from a summator 81. The summator 81 and the capacitor 68 may be replaced by a through-connection if the converter 69 is suitable for converting a digital signal into an analog alternating current signal with positive and negative polarities. In this context it is assumed that the converter 69 can only supply an analog output signal having positive polarity.

The summator 81 receives, at one input, an alternating current signal from a generator 82 which can receive, at an input 83, an accurate and stable voltage Vs for the purpose of generating the alternating current signal with a precise amplitude. Another input of the summator 81 receives a direct voltage Vm which can be half the value of a maximum analog output voltage which the converter 69 is able to supply.

The buffer 80 receives from an input 84 a serial data signal SDAT from an external data source (not shown) and receives, at another input 85, a clock signal CK for the purpose of passing a datum received via the data signal SDAT to the buffer 80.

The capacitor 68, the converter 69, the buffer 80, the summator 81 and the generator 82 form a reference source of the amplifier according to the invention for the purpose of generating said reference signal and supplying it to the second rectifying circuit 62. The datum stored in the buffer 80 determines the amplitude of the reference signal.

The difference amplifier 60 supplies at its output the difference between the derived signal rectified by the first rectifying circuit 61, which signal has been derived from the output voltage Uₒ of the amplifier, and the rectified reference signal. The collector of the transistor 50 supplies a control signal for determining the gain of the input stage 6.

The transistors 10 and 20 form a transadmittance amplifier whose output current is equal to the input voltage Uᵢ divided by the impedance of the emitter circuit of the transistor 10. If the transistor 30 is used in its linear range, the alternating voltage at its collector will be equal to the product of the current coming from the transadmittance amplifier and the value of the resistor 34.

The emitter voltage of the transistor 30 is set at a fixed value. The voltage (control voltage) at the collector of the transistor 50 is determined by a difference signal supplied by the amplifier 60. The peak-to-peak value of the alternating current which can pass through the transistor 30 is at most twice the ratio of the emitter voltage of the transistor 30 and the value of the resistor 31. The peak-to-peak value of the alternating voltage at the collector of the transistor 30 is at most twice the difference of the control voltage at the collector of the transistor 50 and the voltage at the emitter of the transistor 30.

The time constants of the low-pass filters are greater than the cycle time of the alternating current signal received by the rectifying circuit in question.

If the level of the output voltage Uₒ increases, in particular for longer than the time constant of the low-pass filter 71a, 72a, the difference signal at the output of the difference amplifier 60 will increase, which will make the transistor 50 less conducting, as a result of which the control voltage at the collector of the transistor 50 will decrease as will, consequently, the amplitude of the alternating voltage into the output stage 7. Consequently, the level of the output voltage Uₒ will decrease, as a result of which the difference signal at the output of the difference amplifier 60 will decrease, the control voltage at the collector of the transistor 50 will increase again, which will cause the alternating voltage into the output stage 7 and the level of the output voltage Uₒ to increase, and so on, until the loop with the feedback circuit containing the first rectifying circuit 61, the difference amplifier 60 and the transistor 50 is in equilibrium. If the amplitude of the reference signal changes, the amplitude of the output signal Uₒ will follow.

If the rectifying elements 70a and 70b have essentially the same operating characteristics and they are at essentially the same temperature, perturbations of the signals rectified by the rectifying circuits 61 and 62 as a consequence of temperature changes will be compensated by the difference amplifier 60. This enables the accurate presetting of a particular desired level of the output signal Uₒ or the output power of the amplifier, said level subsequently being maintained during use of the amplifier even if the temperature of the rectifying elements 70a, 70b changes.

Experiments have shown that, so long as the shape of the reference signal is essentially identical to the shape of the signal derived from the output signal Uₒ, the frequency of the reference signal may be considerably lower than the average frequency of the output signal Uₒ without impeding efficient operation of the amplifier. One example which may be mentioned involves an average frequency of the output signal Uₒ in the range of 25-50 MHz and a frequency of the reference signal of only 1 kHz. Consequently, the generator 82 may be of much simpler construction than if the frequency of the reference signal had to be higher.

If the signal TXØ is high, which indicates that the transmitter using the amplifier according to the invention is not required to transmit, the non-inverting input of the difference amplifier 60 will be high, which will cause the control voltage of the collector of the transistor 50 to move to a minimum value, as a result of which the level of the output signal Uₒ will decrease to 0.

If the rectifying elements 70a, 70b are formed on the same substrate, this ensures more effectively that they have the same temperature and that perturbations of the rectified signals resulting from temperature changes will be compensated as far as possible by the difference amplifier 60.

Although the invention is explained for the case of an amplifier containing rectifying circuits having a single rectifying element, it will be obvious that the scope of the invention also includes rectifying circuits having more than one rectifying element, for example a diode bridge, and/or those having one or more other semiconductor rectifying elements instead of the diodes 70a and 70b, respectively.

It is also to be noted that, within the scope of the invention, the generator 82 may be adjustable from outside the amplifier, in terms of adjusting the amplitude, the frequency, and the shape of the alternating current signal generated by the generator 82. Generators of this type are known per se and may, depending on the situation, in particular depending on the shape of the output signal Uₒ, be more or less complicated; the generator 82 is therefore not explained here in any further detail.

## Claims

1. Amplifier comprising, in series between an input for receiving an alternating current input signal and an output for supplying an output signal, an input stage and an output stage and, in addition, a feedback circuit between the output and a gain factor control input of the input stage, the feedback circuit having a rectifying circuit with a semiconductor rectifying element for rectifying an alternating current signal derived from the output signal, a reference source for supplying a reference signal, and a difference amplifier for forming the difference between the rectified derived signal and the reference signal, in order to generate and to supply to the control input a control signal for adjusting a gain factor of the input stage, in order to keep the level -of the output signal essentially constant, **characterised in that** the feedback circuit has another rectifying circuit containing another rectifying element which is of the type of the first rectifying element, the difference amplifier receives the reference signal after being rectified by the other rectifying circuit, and the shape of the reference signal is essentially identical to the shape of the derived signal.

2. Amplifier according to Claim 1, **characterised in that** the frequency of the reference signal is lower than the average frequency of the derived signal.

3. Amplifier according to Claim 2, **characterised in that** the frequency of the reference signal is less than 10 kHz.

4. Amplifier according to one of the preceding claims, **characterised in that** the rectifying elements are formed on the same semiconductor substrate.

5. Amplifier according to one of the preceding claims, **characterised in that** the reference source has a digital/analog converter which receives an adjustment value at digital inputs, receives a reference base signal at a reference input, and supplies to an output as a reference signal the product of the adjustment value and the reference base signal.

6. Amplifier according to Claim 5**, characterised in that** the reference source has a generator which generates the reference base signal having essentially the shape of the derived signal.

7. Amplifier according to Claim 6, **characterised in that** the generator is an adjustable generator which generates the reference base signal in accordance with an adjustment value received by the generator.

8. Amplifier according to Claims 5, 6 or 7, **characterised in that** the reference source has a buffer for storing therein an adjustment value for the reference source.

9. Amplifier according to Claim 8, **characterised in that** the adjustment value can be loaded into the buffer from outside the amplifier.
